Europäisches Patentamt

European Patent Office

Office européen des brevets

(11) Publication number: **0 131 514**
**B1**

## EUROPEAN PATENT SPECIFICATION

(45) Date of publication of patent specification: **28.10.87**

(21) Application number: **84401430.8**

(22) Date of filing: **05.07.84**

(51) Int. Cl.⁴: **H 01 L 27/08,** H 01 L 29/78,
H 03 K 19/094

(54) Complementary logic integrated circuit.

(30) Priority: **08.07.83 JP 123498/83**
**08.07.83 JP 123501/83**

(43) Date of publication of application:
**16.01.85 Bulletin 85/03**

(45) Publication of the grant of the patent:
**28.10.87 Bulletin 87/44**

(84) Designated Contracting States:
**DE FR GB**

(56) References cited:
**DE-A-3 013 471**

**PATENTS ABSTRACTS OF JAPAN, vol. 4, no. 8
(E-166), 22nd January 1980, page 103 E 166; &
JP - A - 54 148 469 (OKI DENKI KOGYO K.K.)
20-11-1979**

**PATENTS ABSTRACTS OF JAPAN, vol. 5, no. 3
(E-40)675r, 10th January 1981; & JP - A - 55 134
960 (DAINI SEIKOSHA K.K.) 21-10-1980**

(73) Proprietor: **FUJITSU LIMITED**
**1015, Kamikodanaka Nakahara-ku
Kawasaki-shi Kanagawa 211 (JP)**

(72) Inventor: **Tanizawa, Tetsu**
**7-1-301, Hosoyama 1-chome Asao-ku
Kawasaki-shi Kanagawa, 215 (JP)**
Inventor: **Ohba, Osam**
**536-5-2-303, Ohmaru
Inagi-shi Tokyo 206 (JP)**

(74) Representative: **Descourtieux, Philippe et al
CABINET BEAU de LOMENIE 55 rue
d'Amsterdam
F-75008 Paris (FR)**

Courier Press, Leamington Spa, England.

## Description

The present invention relates to a complementary logic integrated circuit and, more precisely, to a complementary IC (Integrated Circuit) which enables a high speed switching of signals at high current level without increasing power consumptions.

Complementary MIS (C-MIS) type logic circuits are widely used as very low power consumption circuits, but have disadvantages of rather low switching speed and rather low power handling capacity. Therefore, it is difficult to drive large scale and complicated logic circuits by means of C-MIS circuits.

Attempts have been made to overcome such defects of complementary MIS circuit by combining FETs with bipolar transistors, which have high speed and high power handling capacity. But other difficulties have occurred with such improved circuits, and as will be described later, the solution has appeared to be inadequate. Moreover, this solution resulted in an increase of the steps of fabrication, and imposed undesirable effects on the yield, cost and reliability of the devices.

The object of the present invention is, therefore, to provide a complementary logic circuit which has high switching speed and high power handling capacity, and still operates with low power consumption.

Another object of the present invention is to provide a complementary logic circuit which is easy to fabricate by ordinary semiconductor technology.

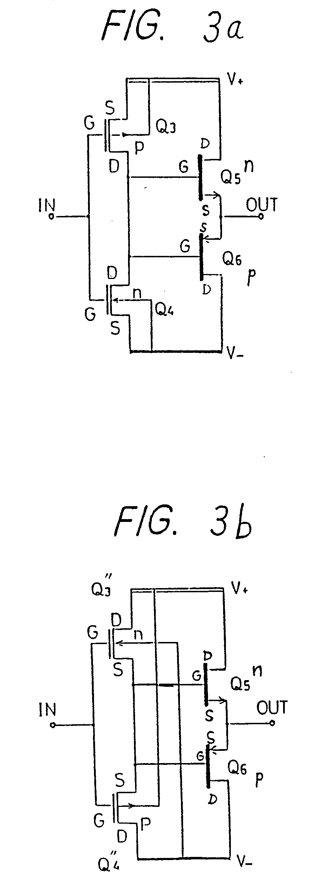

Foregoing objects are attained by combining the C-MIS with complementary vertical FETs, such as claimed. For an inverting type logic (Fig. 3a), the circuit according to the present invention comprises a first (input) stage circuit which is composed of a pair of p-channel and n-channel MIS transistors, and a second (output) stage circuit which is composed of a pair of n-channel and p-channel vertical FETs. For a non-inverting type logic (Fig. 3b), the logic circuit according to the present invention comprises a first (input) stage circuit which is composed of a pair of n-channel and p-channel MIS transistors, and a second (output) stage circuit which is composed of a pair of n-channel and p-channel vertical FETs. Each pair of MIS transistors and vertical FETs forms a respective complementary circuit.

By using complementary vertical FETs, the above mentioned defects of the complementary MIS logic circuit are eliminated, the steps of the fabrication process are reduced and it becomes easy to manufacture the ICs by using conventional semiconductor technology.

The effects and features of the invention will be understood from the following detailed description made with reference to the accompanying drawings.

Fig. 1 shows a conventional prior art complementary logic circuit, wherein

Fig. 1a shows an inverting type circuit; and

Fig. 1b shows a non-inverting type circuit.

Fig. 2 shows a circuit diagram of an improved complementary logic circuit using bipolar transistors wherein:

Fig. 2a shows an inverting type circuit; and

Fig. 2b shows a non-inverting type circuit.

Fig. 3 shows a circuit diagrams of a complementary logic circuit according to the present invention, wherein:

Fig. 3a shows an inverting type circuit; and

Fig. 3b shows a non-inverting type circuit.

Fig. 4 is a partially cutaway view in perspective of a preferred embodiment of the present invention, illustrating the structure of an inverting type complementary logic circuit.

Fig. 5 is a partially cutaway view in perspective of another preferred embodiment of the present invention illustrating the structure of a non-inverting type complementary logic circuit.

In each drawing, figures having a suffix "a" indicate inverting type logic circuits, and figures having a suffix "b" indicate non-inverting type logic circuits. Similar notations or reference numerals designate similar or corresponding parts throughout the drawings.

As mentioned before, though the complementary FET (C-FET) logic circuit has the merits of low power consumption and easy fabrication, it shows also defects.

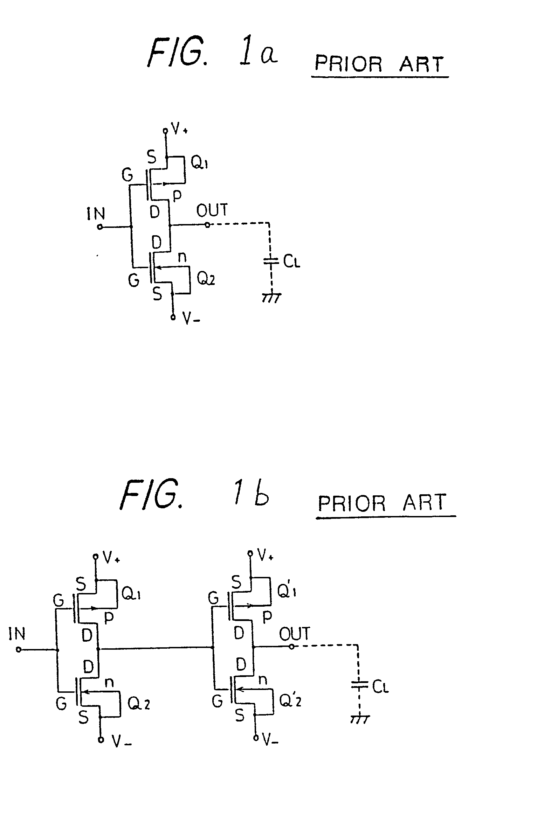

Fig. 1 illustrates examples of prior art complementary logic circuit. Fig. 1a shows a C-MIS (Complementary metal Insulator Semiconductor type) inverter, and Fig. 1b shows a non-inverting logic circuit which is composed of serially connected C-MIS inverters. Each C-MIS inverter circuit is composed of p-channel and n-channel MIS transistors $Q_1$ and $Q_2$ or $Q'_1$ and $Q'_2$, respectively. Source electrodes of each p-channel MIS transistor and n-channel MIS transistor are connected respectively to the positive and negative side of a voltage source V+ and V−.

The input signal IN is applied to the gate electrodes G of the MIS transistors $Q_1$ and $Q_2$, which gate electrodes are connected to each other. The inverted output signal is taken out from drain electrodes D of $Q_1$ and $Q_2$, which are connected to each other, and constitutes the output signal OUT of the inverter. In the non-inverting circuit, the output signal of the first inverter is applied to the second inverter ($Q'_1$ and $Q'_2$), so that the output signal OUT becomes a non-inverted signal.

The operation is as follows. When the input signal is at a high level (H), transistor $Q_1$ is OFF and transistor $Q_2$ is ON; the output signal of the inverter turns to the low level (L). On the contrary, when the input signal is at the low level (L), transistor $Q_1$ is ON and transistor $Q_2$ is OFF and the output signal OUT turns to the high level (H). For the non-inverting circuit, the output signal of the first inverter is inverted once more by a the second inverter $Q'_1$ and $Q'_2$ (the operation of these transistors are reverse to that of the first inverter), and the output signal OUT becomes a non-inverted signal.

In the circuits of Fig. 1, one of the p-channel or n-channel MIS transistors in each inverter stage is OFF as long as the input signal is in stable state, regardless the input signal level is H or L. Therefore, the current which flows directly from the positive side of voltage source V+ to the negative side of voltage source V− through the inverter circuits is always pinched off; thus, the power consumption of the complementary logic circuit becomes very low.

But on the ON-state, the resistance of a MIS transistor is high, so that it is difficult to handle a large current. Moreover, if the circuit is highly integrated or the logic circuit becomes complicated, it is inevitable that the stray capacitance of the circuit becomes large (such stray capacity is indicated by $C_L$ in Fig. 1) and, therefore, when such a large circuit is driven by a C-MIS circuit, the time constant for discharging or charging up the capacitance $C_L$ becomes large, and the operation speed of the circuit becomes low.

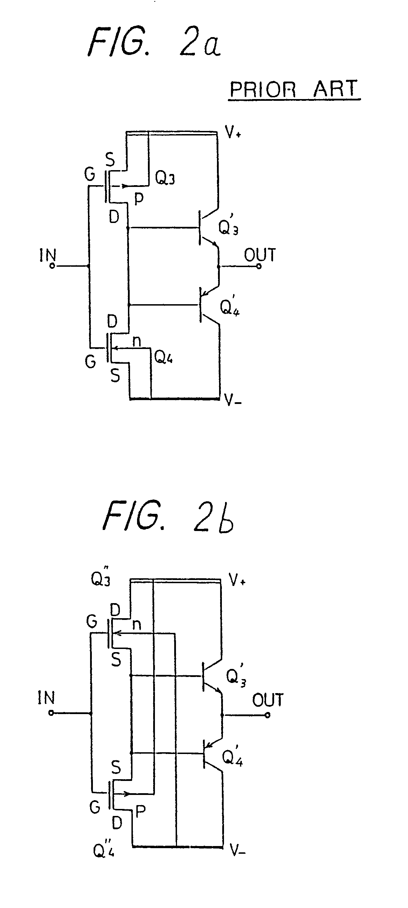

Attempts to overcome such problems have been proposed. The most common one is to combine a MIS transistor with a bipolar transistor (for example, Japanese laid open patents, Publication No.148469/'79 and 45207/'80 by T. Suzuki). These improvements can be summarized as illustrated by Fig. 2. Fig. 2a shows an inverting type circuit corresponding to Fig. 1a. The first stage is of the inverting type with complementary MIS transistors $Q_3$ (p-channel) and $Q_4$ (n-channel), and the second stage is a non-inverting buffer amplifier constituted by complementary bipolar transistors $Q'_3$ (npn) and $Q'_4$ (pnp); when the input signal of the buffer amplifier is H (high) the npn transistor $Q'_3$ is ON and the pnp transistor $Q'_4$ is OFF, so the output signal is H and vice-versa. Therefore, the all over circuit is of the inverting type.

The non-inverting type circuit can be realized by serially connecting inverting type circuits. But it can also be realized as shown on Fig. 2b. The first stage circuit of Fig. 2b is constituted of two non-inverting complementary MIS transistors $Q''_3$ (n-channel) and $Q''_4$ (p-channel). The second stage is similar to that of Fig. 2a. The operation of the circuit can be easily understood by analogy with the preceding description and is therefore omitted from this disclosure for sake of simplicity.

The connection of the bipolar transistors of Fig. 2 is of the emitter follower type; therefore, when the switching action is over and in stable state, the base current is almost zero due to the feed back from the output. For this reason, the current which runs from the positive side of voltage source V+ to the negative side of voltage source V− is almost zero, as in the circuit of Fig. 1.

Such a circuit is commonly used in audio signal amplifiers and it is known that there is a "dead zone" in which the speed of the switching action becomes very low (in audio amplifiers the distortion increases and many improvements are proposed), when the input signal is at a particular level meeting the following condition:

$$\text{Buffer OUT} - V_{BE} < \text{Buffer IN} < \text{Buffer OUT} + V_{BE} \tag{1}$$

where Buffer OUT and Buffer IN are the signal levels of the output and input signals of the bipolar transistors respectively, and $V_{BE}$ is the threshold voltage of the bipolar transistor. The reason can be explained as follows. Assuming that the input level of the buffer stage (second stage) is in H state (high), the transistor $Q'_3$ is ON and the output level (Buffer OUT) becomes $V_H - V_{BE}$, where $V_H$ is the signal level of the H state. In this condition, Buffer IN=Buffer OUT+$V_{BE}$. When the switching action begins, the level of Buffer IN decreases, but Buffer OUT remains at $V_H - V_{BE}$ due to the stray capacity of the load. As Buffer IN decreases, it becomes lower than Buffer OUT+$V_{BE}$, and the transistor $Q'_3$ turns OFF. In this condition, the transistor $Q'_4$ is still OFF, and, therefore, the stray capacity is not discharged, since both transistors $Q'_3$ and $Q'_4$ are OFF. At this moment, the switching action is lost. Such "dead state" continues until Buffer IN decreases to Buffer OUT−$V_{BE}$. This constitutes the "dead zone". When Buffer IN becomes lower than Buffer OUT−$V_{BE}$, the transistor $Q'_4$ turns ON, and Buffer OUT is pulled down quickly.

Similarly, when Buffer IN is in L state (low), the transistor $Q'_4$ is ON and $Q'_3$ is OFF, and Buffer OUT=$V_L + V_{BE}$, where $V_L$ is the signal level of the L state. Therefore, Buffer IN=Buffer OUT−$V_{BE}$. As the switching action begins, the level of Buffer IN increases, but Buffer OUT remains to its initial value $V_L + V_{BE}$. Therefore, the transistor $Q'_4$ turns OFF and the "dead zone" begins and continues until Buffer IN=Buffer OUT+$V_{BE}$. When Buffer IN exceeds this value, the transistor $Q'_3$ turns ON and Buffer OUT is pulled up rapidly.

Likewise, each time the signal changes from H to L or vice-versa, the signal level must cross the dead zone. $V_{BE}$ is approximately 0.8 volt; therefore the width of the dead zone is approximately 1.6 volt. This value is relatively large compared to the source voltage or the level of the signal H, which is usually about 5 volts. Therefore, the switching speed is very much decreased.

The present invention intends to improve the above defect by replacing the bipolar transistors by vertical FETs. A vertical FET is a field effect transistor whose channel is provided vertically to the surface of the transistor (ordinary FET has a channel parallel to the surface of the device). Vertical FET is known from the early stage of FET technology (for example, by J. Nishizawa et al, "Field Effect Transistor vs. Analog Transistor" IEEE Transaction on Electron Devices ED-22, No. 4, Apr. 1975 or by J. Nishizawa "Static Induction Transistor Logic" Jap. Journal of Applied Physics, Vol. 17, 1978 Supplement 17-1), but was not used so widely, because of the complexity of fabrication compared with ordinary FETs. However, it has been discovered that when the vertical FET is used for the buffer stage of the complementary MIS (C-MIS) circuit, it shows many advantages which makes it possible to overcome the defects of the known C-MIS circuits.

Fig. 3 shows circuit diagrams of a complementary logic circuit according to the present invention. Fig. 3a is a circuit diagram for an inverting type circuit, and Fig. 3b for a non-inverting type circuit. These circuits correspond to those of Fig. 2a and Fig. 2b, respectively, with the buffer stage transistors $Q'_3$ and $Q'_4$ being replaced by vertical FETs $Q_5$ (n-channel) and $Q_6$ (p-channel), respectively. The operation is quite similar to that of circuits of Fig. 2. Namely, the first stage is an inverting (Fig. 3a) or non-inverting (Fig. 3b) C-MIS type stage, respectively, and the second stage (buffer stage) is a non-inverting complementary vertical FETs type stage.

The power handling capacity of a vertical FET being large, the first defect of a C-MIS circuit, that is a small power handling capacity, is eliminated. Another defect of the bipolar buffer stage circuit, i.e. the dead zone, can be eliminated by reducing $V_{BE}$. As can be seen from the condition (1), the dead zone can be reduced by reducing $V_{BE}$. The threshold voltage $V_{BE}$ of a bipolar transistor is determined by material, therefore, it is almost impossible to reduce it. On the contrary, a V-FET can be designed as a normally ON type device (it can be designed also as a normally OFF type) and the threshold voltage is lower than that of a bipolar transistor; moreover, with a vertical FET, the threshold voltage may be freely reduced by increasing the width of the channel. It may also be reduced by increasing the conductivity of the channel, by varying the impurity. Generally, a C-MIS is a surface device, that is all the device is fabricated on the surface of the substrate, when, on the contrary, a V-FET (vertical FET) is buried into the substrate; therefore, it is possible to vary the impurity of the substrate partially in the zone of the V-FET, without disturbing the surface devices. Therefore, it is possible to reduce the threshold voltage almost to zero. As a result, the dead zone is eliminated.

Each of the complementary vertical FETs is connected in series between the positive and negative voltage source, and in any state of the signal (L or H), one of the vertical FETs is in the OFF state. The current flowing directly from positive source to negative source is then always pinched off; therefore, the dark current or power consumption of the circuit is very small.

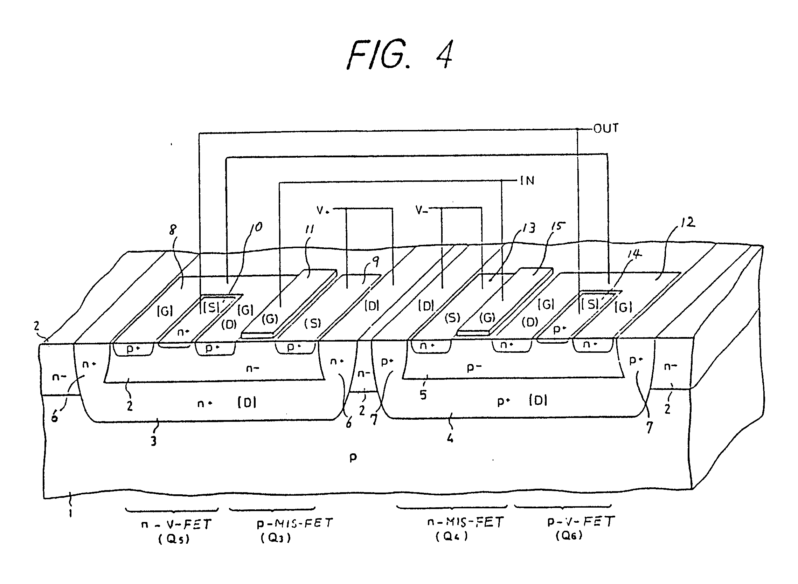

Further details of the invention will be disclosed with regard to some embodiments of the circuit according to the invention. Fig. 4 is a partially cutaway view showing the structure of a device embodying the circuit of Fig. 3a. On Fig. 4, the reference numeral 1 designates a p-type substrate, upon which a n⁻-type epitaxial layer 2 is formed, this layer being lightly doped with a n-type impurity. On the boundary of the p-type substrate 1 and epitaxial layer 2 are formed a n⁺-type buried layer 3 and a p⁺-type buried layer 4. These buried layers are formed before the epitaxial layer 2 is formed. Using a conventional method, the buried layers are linked to the surface of the substrate respectively by a n⁺-type region 6 and a p⁺-type region 7. These regions are fabricated by usual diffusion or ion implantation technology. On the surface of the n⁻-layer 2, a first p⁺-region 8 and a second p⁺-region 9 are formed; the regions 8 and 9 can be fabricated at the same time. Then a first n⁺-region 10 is fabricated. As can be seen on figure 4, the first p⁺-type region 8 is shaped to surround the first n⁺-type region 10. These regions are fabricated by using a conventional method such as photo-lithographic masking and diffusion or ion implantation technology, and the surface of the substrate is covered with insulating film (not shown). Over the insulating film, a gate electrode 11 is fabricated. Usually, the gate electrode is made of aluminum, or highly doped poly-silicon (poly-crystalline silicon).

By such a process, in the n⁻-type epitaxial layer 2 lying over the n⁺-type buried layer 3 are formed a p-type MIS-FET (Metal Insulator Semiconductor type Field Effect Transistor) $Q_3$ and a n-channel V-FET $Q_5$. The p-channel FET $Q_3$ comprises a drain which is the first p⁺-region 8, denoted (D) on figure 4, a gate 11 denoted (G) and a source which is the second p⁺-region 9, denoted (S). The n-channel V-FET $Q_5$ comprises a source which is the first n⁺-region 10, denoted [S], a gate which is the first p⁺-region 8, denoted [G] and a drain which is the buried n⁺-layer 3, denoted [D].

It will be understood for the one skilled in the art that it is easy to fabricate these transistors by conventional semiconductor technlogy. Moreover, it will be seen from the figure, that a part of the gate [G] of the V-FET $Q_5$ is serving as the drain (D) of the p-channel FET $Q_3$. Therefore, the wiring to connect the gate [G] of the V-FET $Q_5$ to the drain (D) of the p-channel FET $Q_3$ can be eliminated. As a consequence, a step of the process of fabrication of the device is saved, and the packing density of the devices on the IC chip is increased.

On the upper part of the P⁺ buried layer 4 is formed a p⁻-layer 5 which is lightly doped by p-type impurity. This layer is formed by converting the n⁻-layer 2, which is formed on the buried layer 4, by doping with p-type impurity by conventional diffusion or ion implantation technology. From the surface of the p⁻-layer 5, are formed a second n⁺-region 12, a third n⁺-region 13 and a third p⁺-region 14, and a gate electrode 15 is formed on the surface of the p⁻-layer. These are fabricated by a method similar to the one described before.

In such a manner, a n-channel MIS-FET $Q_4$ and a p-channel V-FET $Q_6$ are formed on the p⁻-layer 5 lying over the p⁺-type buried layer 4. The n-channel FET $Q_4$ comprises a drain which is the second n⁺-region 12, denoted (D) on figure 4, a gate 15 denoted (G) and a source which is the third n⁺-region 13, denoted (S). The p-channel V-FET $Q_6$ comprises a source which is the third p⁺-region 14, denoted [S], a gate which is the second n⁺-region 12, denoted [G] and a drain which is the buried p⁺-layer 4, denoted [D]. The second n⁺-region 12 is surrounding the third p⁺-region 14, and is serving as gate electrode for the p-channel V-FET $Q_6$ and drain electrode for the n-channel MIS-FET $Q_4$. It will be clear for the one skilled in the art that same advantages are obtained as described before, regarding the simplification of the process and the packing density.

When the fabrication of the devices described hereinbefore is completed, the substrate is coated by a passivation film, and after making of contact holes corresponding to respective electrode, the wiring is made by using a usual process in semiconductor device manufacturing. Such processes are all the same and familiar in conventional semiconductor device manufacturing; therefore the disclosure of such processes are omitted for sake of simplicity. For example, the electrodes of the devices are thus connected as shown on Fig. 4. In this figure, the gate electrodes of the p-channel FET $Q_3$ and the n-channel FET $Q_4$ are connected to each other and to an input terminal IN. The source electrodes of the n-channel V-FET $Q_5$ and p-channel V-FET $Q_6$ are connected to each other and to the output terminal OUT. The gate electrodes of n-channel V-FET $Q_5$ and p-channel V-FET $Q_6$ are connected to each other. The drain electrode of the n-channel V-FET $Q_5$ and the source electrode of the p-channel FET $Q_3$ are connected to each other and to the positive side of voltage source V+, and the source electrode of the n-channel FET $Q_4$ and the drain electrode of the p-channel V-FET $Q_6$ are connected to each other and to the negative side of voltage source V−.

As can be seen on Figure 4, the channel regions of the p-channel FET $Q_3$ and n-channel FET $Q_4$ are connected respectively to the drain of the n-channel V-FET $Q_5$ and p-channel V-FET $Q_6$, so that each channel region is biased with positive and negative supply voltage V+ and V− respectively. Thus the circuit shown in Fig. 3a is realized.

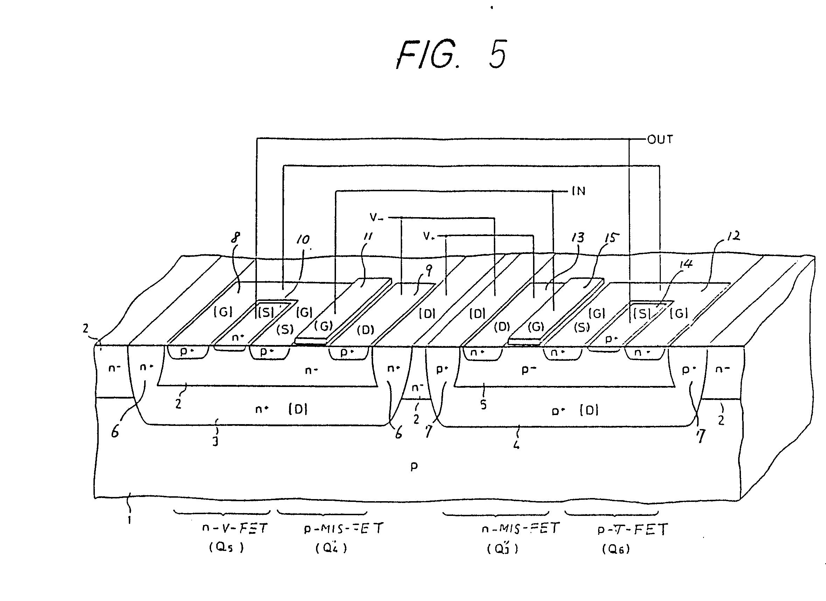

Once the device having the pattern shown by Fig. 4 is fabricated, which corresponds to the inverting type logic circuit shown in Fig. 3a, it is quite easy to change it to the non-inverting type logic circuit of Fig. 3b. Fig. 5 shows the structure of the device embodying the circuit of Fig. 3b. Comparing Fig. 5 and Fig. 4, one will notice that the patterns of electrodes fabricated in the bulk of semiconductor are quite the same. The difference lies in a slight alteration of the power supply connection; namely the second $p^+$-region 9 and the drain 7 of the p-channel V-FET are connected to each other and to V−, and the drain 6 of the n-channel V-FET and the third $n^+$-region 13 are connected to each other and to V+. And if the designation of the p-channel MIS-FET $Q_3$ is changed to $Q''_4$, and the designation of the n-channel MIS-FET $Q_4$ is changed to $Q''_3$, then the device becomes nothing but the circuit of Fig. 3b.

This is an important advantage of the complementary logic circuit by the present invention. Namely, when the device having the pattern of Fig. 4 is fabricated, it can be easily used as an inverting type logic circuit or as a non-inverting type logic circuit merely by varying the wiring of the source voltage; there is no need to change the pattern and the processing of diffusion, ion implantation and photo-lithograph etc. which are the main steps of semiconductor device fabrication. Moreover, there is no need to prepare different mask patterns for inverting and non-inverting circuit respectively. These advantages are quite significant for the manufacturing of the ICs. The number of steps of the production processing are decreased and the cost is reduced. The design freedom of the ICs is increased, and, as mentioned before, the packing density is also increased.

It will be clear from the above description, that the complementary logic circuits according to the present invention do not require any new process or device to fabricate them. They can be fabricated by conventional semiconductor processes.

**Claims**

1. A complementary logic IC (Integrated Circuit) comprising:
   a first stage circuit in which a p-channel MIS-FET (Metal Insulator Semiconductor type Field Effect Transistor) ($Q_3$; $Q''_4$) and a n-channel MIS-FET ($Q_4$; $Q''_3$); are connected in series between a positive and a negative voltage source (V+, V−) so as to provide a C-MIS circuit and
   an output stage circuit in which a n-channel V-FET (Vertical FET) ($Q_5$) and a p-channel V-FET ($Q_6$), are connected in series between a positive and a negative voltage source (V+, V−) so as to provide a complementary vertical buffer circuit,
   wherein the gate electrodes (11, 15) of said MIS-FETs ($Q_3$, $Q_4$; $Q''_4$, $Q''_3$) are connected to each other and receive an input signal (IN);
   the source electrodes (10, 14) and the gate electrodes of said V-FETs ($Q_5$, $Q_6$) are connected to each other and provide an output signal (OUT);
   said p-channel MIS-FET ($Q_3$; $Q''_4$) and said n-channel V-FET ($Q_5$) are fabricated adjoined each other, such that a part of the gate (8) of said n-channel V-FET ($Q_5$) serves as one of the drain or the source of said p-channel MIS-FET ($Q_3$; $Q''_4$); and
   said n-channel MIS-FET ($Q_4$; $Q''_3$) and said p-channel V-FET ($Q_6$) are fabricated adjoined each other, such that a part of the gate (12) of said p-channel V-FET ($Q_6$) serves as one of the drain or the source of said n-channel MIS-FET ($Q_4$; $Q''_3$).

2. Complementary logic IC according to claim 1, in which:
   said part of the gate (8) of said n-channel V-FET ($Q_5$) serves as the drain of said p-channel MIS-FET ($Q_3$);
   said part of the gate (12) of said p-channel V-FET ($Q_6$) serves as the drain of said n-channel MIS-FET ($Q_4$);
   the drain (6) of said n-channel V-FET ($Q_5$) is connected to the source (9) of said p-channel MISFET ($Q_3$) and supplied with the positive source voltage (V+); and
   the drain (7) of said p-channel V-FET ($Q_6$) is connected to the source (13) of said n-channel MIS-FET ($Q_4$) and supplied with a negative source voltage (V−).

3. Complementary logic IC according to claim 1, in which:

said part of the gate (8) of said n-channel V-FET (Q5) serves as the source of said p-channel MIS-FET (Q''4);

said part of the gate (12) of said p-channel V-FET (Q6) serves as the source of said n-channel MIS-FET (Q''3);

the drain (6) of said n-channel V-FET (Q5) is connected to the drain (13) of said n-channel MIS-FET (Q''3) and supplied with the positive source voltage (V+); and

the drain (7) of said p-channel V-FET (Q6) is connected to the drain (9) of said p-channel MIS-FET (Q''4) and supplied with a negative source voltage (V−).

4. Complementary logic IC according to any of the preceding claims comprising:

a p-type semiconductor substrate (1), on which the IC circuit is fabricated;

a n−-type layer (2) formed upon said substrate (1);

n-type and p-type buried layers (3, 4) fabricated between the p-type substrate (1) and said n−-layer (2), each of the buried layer being doped highly with n-type and p-type dopant respectively, and being respectively connected to the surface of the substrate by highly doped regions (6, 7) of respective type of conductivity fabricated at the periphery of the buried layers (3, 4); and

n−-layer (2) and p−-layer (5) respectively lightly doped with n-type and p-type dopant and respectively fabricated on said n-type buried layer (3) and p-type buried layer (4),

wherein said n−-layer comprises a p-channel MIS-FET (Q3; Q''4) and a n-channel V-FET (Q5) fabricated adjoined each other so that a part of the gate (8) of said n-channel V-FET (Q5) serves as the drain or source of said p-channel MIS-FET (Q3; Q''4); and

said p−-layer comprises a n-channel MIS-FET (Q4, Q''3) and a p-channel V-FET (Q6) fabricated adjoined each other so that a part of the gate (12) of said p-channel V-FET (Q6) serves as the drain or source of said n-channel MIS-FET (Q4; Q''3).

5. Complementary logic IC according to claim 4, in which:

said n−-layer (2) comprises:

a first n+-region (10) which is highly doped with n-type dopant and fabricated at the surface portion of said n−-layer (2); so as to form the source of the n-channel V-FET (Q5)

a first p+-region (8) which is highly doped with p-type dopant and fabricated at the surface portion of said n−-layer (2) so as to form the gate of said n-channel V-FET (Q5) and simultaneously the source or drain of the p-channel MIS-FET;

a second p+-region (9) which is highly doped with p-type dopant and fabricated at the surface portion of said n−-layer (2), so as to form the source or drain of the p-channel MIS-FET

an isolated gate electrode (11) fabricated on the surface of said n−-layer (2) between first and second p+-regions (8, 9)

said p−-layer (5) comprises:

a third p+-region (14) which is highly doped with p-type dopant and fabricated at the surface portion of said p−-layer (5) so as to form the source of the p-channel V-FET (Q6);

a second n+-region (12) which is highly doped with n-type dopant and fabricated at the surface portion of said p−-layer (5); so as to form the gate of said p-channel V-FET (Q6) and simultaneously the drain or source of the n-channel MIS-FET

a third n+-region (13) which is highly doped with n-type dopant and fabricated at the surface portion of said p−-layer (5) so as to form the source or drain of the n-channel MIS-FET;

an isolated gate electrode (15) fabricated on the surface of said p−-layer (5) between second and third n+-regions (12, 13).

6. Complementary logic IC according to claim 5, wherein:

said first p+-region (8) is fabricated around said first n+-region (10); and

said second n+-region (12) is fabricated around said third p+-region (14).

7. Complementary logic circuit, having an input terminal for receiving an input signal and an output terminal for providing an inverted output signal, in which:

a source voltage supply is provided with a positive side (V+) and a negative side (V−) terminals;

a first stage circuit comprises a p-channel MIS-FET (Q3) and n-channel MIS-FET (Q4),

said p-channel MIS-FET (Q3) having a source (9) connected to the positive side terminal (V+), and a gate (11) connected to the input terminal (IN),

said n-channel MIS-FET (Q4) having a drain (12) connected to a drain (8) of the p-channel MIS-FET (Q3), a gate (15) connected to the input terminal (IN), and a source (13) connected to the negative side terminal (V−),

the channel region of said p-channel MIS-FET (Q3) and n-channel MIS-FET (Q4) being respectively biased with positive (V+) and negative (V−) voltage of said voltage supply, and

an output stage circuit comprises a p-channel V-FET (Q6) and a n-channel V-FET (Q5),

said n-channel V-FET (Q5) having a drain (6) connected to the positive side terminal (V+), a gate (8) connected to the drain of the p-channel MIS-FET (Q3), and a source (10) connected to the output terminal (OUT), and

said p-channel V-FET (Q6) having a source (14) connected to the output terminal (OUT), a gate (12) connected to the drain of the n-channel MIS-FET (Q4), and a drain (7) connected to the negative side terminal (V−).

8. Complementary logic circuit, having an input terminal for receiving an input signal and an output terminal for providing a non-inverted output signal, in which:

a source voltage supply is provided with a positive side (V+) and a negative side (V−) terminals;

a first stage circuit comprises a n-channel MIS-FET (Q''3) and p-channel MIS-FET (Q''4),

said n-channel MIS-FET (Q''3) having a drain (13) connected to the positive side terminal (V+), and a gate (15) connected to the input terminal (IN),

said p-channel MIS-FET (Q''4) having a source (8) connected to a source (12) of the n-channel MIS-FET (Q''3), a gate (11) connected to the input terminal (IN), and a drain (9) connected to the negative side terminal (V−),

the channel regions of said n-channel MIS-FET (Q''3) and p-channel MIS-FET (Q''4), are respectively biased with negative (V−) and positive (V+) voltage of said voltage supply, and

an output stage circuit comprises a p-channel V-FET (Q6) and a n-channel V-FET (Q5),

said n-channel V-FET (Q5) having a drain (6) connected to the positive side terminal (V+), a gate (8) connected to the source of the p-channel MIS-FET (Q''4), and a source (10) connected to the output terminal (OUT), and

said p-channel V-FET (Q6) having a source (14) connected to the output terminal (OUT), a gate (12) connected to the source of the n-channel MIS-FET (Q''3), and a drain (7) connected to the negative side terminal (V−).

**Patentansprüche**

1. Komplementäre Logik-IC (Integrierte Schaltung) mit:

einer ersten Stufenschaltung, in welcher ein p-Kanal-MIS-FET (Feldeffekttransistor vom Metallisolatorhalbleitertyp) (Q3; Q''4) und ein n-Kanal-MIS-FET (Q4; Q''3) in Reihe zwischen einer positiven und einer negativen Spannungsquelle (V+, V−) verbunden sind, um so eine C-MIS-Schaltung zu bilden, und

einer Ausgansstufenschaltung, in der ein n-Kanal-V-FET (vertikaler FET) (Q5) und ein p-Kanal-V-FET (Q6) in Reihe zwischen einer positiven und einer negativen Spannungsquelle (V+, V−) so verbunden sind, daß sie eine komplementäre vertikale Pufferschaltung bilden,

bei welcher die Gateelektroden (11, 15) der genannten MIS-FET (Q3, Q4; Q''4, Q''3) miteinander verbunden sind und ein Eingangssignal (IN) empfangen;

die Sourceelektroden (10, 14) und die Gateelektroden der genannten V-FET (Q5, Q6) miteinander verbunden sind und ein Ausgangssignal (OUT) liefern;

der genannte p-Kanal-MIS-FET (Q3; Q''4) und der genannte n-Kanal-V-FET (Q5) aneinander angrenzend hergestellt sind, so daß ein Teil des Gate (8) des genannten n-Kanal-V-FET (Q5) als entweder Drain oder Source des genannten p-Kanal-MIS-FET (Q3; Q''4) dient; und

der genannte n-Kanal-MIS-FET (Q4; Q''3); und der genannte p-Kanal-V-FET (Q6) aneinander angrenzend hergestellt sind, so daß ein Teil des Gate (12) des genannten p-Kanal-V-FET (Q6) als entweder Drain oder Source des genannten n-Kanal-MIS-FET (Q4; Q''3) dient.

2. Komplementäre Logik-IC nach Anspruch 1, bei der:

der Teil des Gate (8) des genannten n-Kanal-V-FET (Q5) als Drain des genannten p-Kanal-MIS-FET (Q3) dient;

das Teil des Gate (12) des genannten p-Kanal-V-FET (Q6) als das Drain des genannten n-Kanal-MIS-FET (Q4) dient; das Drain (6) des genannten n-Kanal-V-FET (Q5) mit der Source (9) des genannten p-Kanal-MIS-FET (Q3) verbunden ist und ihm die positive Quellenspannung (V+) zugeführt wird; und

das Drain (7) des genannten p-Kanal-V-FET (Q6) mit der Source (13) des genannten n-Kanal-MIS-FET (Q4) verbunden ist und ihm eine negative Quellenspannung (V−) zugeführt wird.

3. Komplementäre Logik-IC nach Anspruch 1, bei der:

das genannte Teil des Gate (8) des genannten n-Kanal-V-FET (Q5) als die Source des genannten p-Kanal-MIS-FET (Q''4) dient;

das genannte Teil des Gate (12) des genannten p-Kanal-V-FET (Q6) als die Source des genannten n-Kanal-MIS-FET (Q''3) dient;

das Drain (6) des genannten n-Kanal-V-FET (Q5) mit dem Drain (13) des genannten n-Kanal-MIS-FET (Q''3) verbunden ist und ihm die positive Quellenspannung (V+) zugeführt wird; und

das Drain (7) des genannten p-Kanal-V-FET (Q6) mit dem Drain (9) des genannten p-Kanal-MIS-FET (Q''4) verbunden ist und ihm eine negative Quellenspannung (V−) zugeführt wird.

4. Komplementäre Logik-IC nach einem der vorhergehenden Ansprüche, mit:

einem Halbleitersubstrat (1) vom p-Typ (auf dem die IC-Schaltung hergestellt ist;

einer n-Typ-Schicht (2), die auf dem genannten Substrat gebildet ist;

vergrabene n-Typ- und p-Typ-Schichten (3,4), die zwischen dem p-Typ-Substat (1) und der genannten n⁻-Schicht (2) hergestellt sind, wobei jede vergrabene Schicht mit einem n-Typ bzw. einem p-Typ-Dotierungsmittel hoch dotiert ist und jeweils mit der Oberfläches des Substrates durch hoch dotierte Bereiche (6,7) von entsprechendem Leitfähigkeitstyp verbunden sind, die an der Peripherie der vergrabenen Schichten (3,4) hergestellt sind;

. eine n⁻-Schicht (2) und eine p⁻-Schicht (5), die jeweils leicht mit einem n-Typ- bzw. einem p-Typ-Dotierungsmittel dotiert sind und auf der genannten vergrabenen Schicht (3) vom n-Typ bzw. der vergrabenen Schicht (4) vom p-Typ hergestellt sind,

in welcher die n⁻-Schicht einen p-Kanal-MIS-FET (Q3; Q''4) und einen n-Kanal-V-FET (Q5 umfaßt, die aneinander angrenzend so hergestellt sind, daß ein Teil des Gate (8) des genannten n-Kanal-V-FET (Q5) als Drain oder Source des genannten p-Kanal-MIS-FET (Q3; Q''4) dient; und

die genannte p⁻-Schicht einen n-Kanal-MIS-FET (Q4, Q''3) und einen p-Kanal-V-FET (Q6) umfaßt, die aneinander angrenzend so hergestellt sind, daß ein Teil des Gate (12) des genannten p-Kanal-V-FET (Q6) als Drain oder Source des genannten n-Kanal-MIS-FET (Q4; Q''3) dient.

5. Komplementäre Logik-IC nach Anspruch 4, bei welcher:

die genannte n⁻-Schicht (2) umfaßt:

einen ersten n⁺-Bereich (10), der mit einem n-Typ-Dotierungsmittel hoch dotiert ist und bei dem Oberflächenabschnitt der genannten $n^-$-Schicht (2) so hergestellt ist, daß er die Source des n-Kanal-V-FET ($Q_5$) bildet,

einen ersten $p^+$-Bereich (8), der mit einem p-Typ-Dotierungsmittel hoch dotiert ist und bei dem Oberflächenabschnitt der genannten $n^-$-Schicht (2) so hergestellt ist, daß er das Gate des genannten n-Kanal-V-FET ($Q_5$) und gleichzeitig die Source oder Drain des p-Kanal-MIS-FET bildet,

einen zweiten $p^+$-Bereich (9), der mit einem p-Typ-Dotierungsmittel hoch dotiert ist und bei dem Oberflächenabschnitt der genannten $n^-$-Schicht (2) so hergestellt ist, daß er die Source oder das Drain des p-Kanal-MIS-FET bildet,

und eine isolierte Gateelektrode (11), die auf der Oberfläche der genannten $n^-$-Schicht (2) zwischen ersten und zweiten $p^+$-Bereichen (8, 9) hergestellt ist;

die genannte $p^-$-Schicht (5) umfaßt:

einen dritten $p^+$-Bereich (14), der mit einem p-Typ-Dotierungsmittel bei dem Oberflächenabschnitt der genannten $p^-$-Schicht (5) so hergestellt ist, daß er die Source des p-Kanal-V-FET ($Q_6$) bildet,

einen zweiten $n^+$-Bereich (12), der mit einem n-Typ-Dotierungsmittel hoch dotiert ist und bei dem Oberflächenabschnitt der genannten $p^-$-Schicht (5) so hergestellt ist, daß er das Gate des genannten p-Kanal-V-FET ($Q_6$) und gleichzeitig das Drain oder die Source des n-Kanal-MIS-FET bildet,

einen dritten $n^+$-Bereich (13), der mit einem n-Typ-Dotierungsmittel hoch dotiert ist und bei dem Oberflächenabschnitt der $p^-$-Schicht (5) so hergestellt ist, daß er die Source oder das Drain des n-Kanal-MIS-FET bildet,

eine isolierten Gateelektrode (15), die auf der Oberfläche der genannten $p^-$-Schicht (5) zwischen zweiten und dritten $n^+$-Bereichen (12, 13) hergestellt ist.

6. Komplementäre Logik-IC nach Anspruch 5, bei der

der genannte erste $p^+$-Bereich (8) um den genannten ersten $n^+$-Bereich (10) hergestellt ist; und

der genannte zweite $n^+$-Bereich (12) um den genannten dritten $p^+$-Bereich (14) hergestellt ist.

7. Komplementäre Logikschaltung, mit einem Eingangsanschluß zum Empfang eines Eingangsignals und einem Ausgangsanschluß zur Lieferung eines invertierten Ausgangssignals, bei der:

eine Quellenspannungsversorgung mit einem Plusseiten-(V+) und ein Minusseitenanschluß (V−) vorgesehen ist;

eine erste Stufenschaltung einen p-Kanal-MIS-FET ($Q_3$) und einen n-Kanal-MIS-FET ($Q_4$) umfaßt,

der genannte p-Kanal-MIS-FET ($Q_3$) eine Source (9) hat, die mit dem Plusseitenanschluß (V+) verbunden ist, und ein Gate (11), das mit dem Eingangsanschluß (IN) verbunden ist,

der genannte n-Kanal-MIS-FET ($Q_4$) ein Drain (12) hat, das mit einem Drain (8) des p-Kanal-MIS-FET ($Q_3$) verbunden ist, ein Gate (15), das mit dem Eingangsanschluß (IN) verbunden ist, und eine Source (13), die mit dem Minusseitenanschluß (V−) verbunden ist,

die Kanalbereiche des genannten p-Kanal-MIS-FET ($Q_3$) und des n-Kanal-MIS-FET ($Q_4$) mit einer positiven (V+) bzw. einer negativen (V−) Spannung der genannten Spannungsversorgung vorgespannt sind, und

eine Ausgangsstufenschaltung einen p-Kanal-V-FET ($Q_6$) und einen n-Kanal-V-FET ($Q_5$) umfaßt,

welcher genannte n-Kanal-V-FET ($Q_5$) ein Drain (6) hat, das mit dem Plusseitenschluß (V+) verbunden ist, ein Gate (8), das mit dem Drain des p-Kanal-MIS-FET ($Q_3$) verbunden ist und eine Source (10), die mit dem Ausgangsanschluß (OUT) verbunden ist, und

der genannte p-Kanal-V-FET ($Q_6$) eine Source (14) hat, die mit dem Ausgangsanschluß (OUT) verbunden ist, ein Gate (12), das mit dem Drain des n-Kanal-MIS-FET ($Q_4$) verbunden ist, und ein Drain (7), das mit dem Minusseitenanschluß (V−) verbunden ist.

8. Komplementäre Logikschaltung mit einem Eingangsanschluß zum Empfang eines Eingangsignals und einem Ausgangsanschluß zum Liefern eines nicht invertierten Ausgangssignals, bei der:

eine Quellenspannungsversorgung mit einem Plusseiten- (V+) und einem Minusseitenanschluß (V−) vorgesehen ist;

eine erste Stufenschaltung einen n-Kanal-MIS-FET ($Q''_3$) und einen p-Kanal-MIS-FET ($Q''_4$) umfaßt,

der n-Kanal-MIS-FET ($Q''_3$) ein Drain (13) hat, das mit dem Plusseitenanschluß (V+) verbunden ist, und ein Gate (15), das mit dem Eingangsanschluß (IN) verbunden ist,

der genannte p-Kanal-MIS-FET ($Q''_4$) eine Source (8) hat, die mit einer Source (12) des n-Kanal-MIS-FET ($Q''_3$) verbunden ist, ein Gate (11), das mit dem Eingangsanschluß (IN) verbunden ist, und ein Drain (9), das mit dem Minusseitanschluß (V−) verbunden ist,

wobei die Kanalbereiche des genannten n-Kanal-MIS-FET ($Q''_3$) und des p-Kanal-MIS-FET ($Q''_4$) mit einer Negativspannung (V−) bez. einer Positivspannung (V+) der genannten Spannungsversorgung verbunden sind, und

eine Ausgangsstufe einen p-Kanal-V-FET ($Q_6$) und einen n-Kanal-V-FET ($Q_5$) umfaßt,

wobei der genannte n-Kanal-V-FET ($Q_5$) ein Drain (6) hat, das mit dem Plusseitenanschluß (V+) verbunden ist, ein Gate (8), das mit der Source des p-Kanal-MIS-FET ($Q''_4$) verbunden ist, und eine Source (10), die mit dem Ausgangsanschluß (OUT) verbunden ist und,

der genannte p-Kanal-V-FET ($Q_6$) eine Source (14) hat, die mit dem Ausgangsanschluß (OUT) verbunden ist, ein Gate (12), das mit der Source des n-Kanal-MIS-FET ($Q''_3$) verbunden ist, und ein Drain (7), das mit dem Minusseitenaschluß (V−) verbunden ist.

**Revendications**

1. Circuit intégré logique complémentaire comprenant:

un circuit de premier étage dans lequel un MIS-FET (transistor à effet de champ du type métal-isolant-semiconducteur) à canal p (Q$_3$; Q''$_4$) et un MIS-FET à canal n (Q$_4$; Q''$_3$) sont connectés en série entre une source de tension positive et de tension négative (V+, V−) afin de produire un circuit C-MIS; et

un circuit d'étage de sortie dans lequel un V-FET (FET vertical) à canal n (Q$_5$) et un V-FET à canal p (Q$_6$) sont connectés en série entre une source de tension positive et une source de tension négative (V+, V−) afin de produire un circuit tampon vertial complémentaire,

où les électrodes de grille (11, 15) desdits MIS-FET Q$_3$, Q$_4$; Q''$_4$, Q''$_3$) sont connectées ensemble et reçoivent un signal d'entrée (IN);

les électrodes de source (10, 14) et les électrodes de grille des V-FET (Q$_5$, Q$_6$) sont connectées ensemble et produisent un signal de sortie (OUT);

ledit MIS-FET à canal p (Q$_3$; Q''$_4$) et ledit V-FET à canal n (Q$_5$) sont fabriques conjointement de sorte qu'une partie de la grille (8) dudit V-FET à canal n (Q$_5$) fait fonction du drain ou de la source dudit MIS-FET à canal p (Q$_3$; Q''$_4$); et

ledit MIS-FET à canal n (Q$_4$; Q''$_3$) et ledit V-FET à canal p (Q$_6$) sont fabriqués conjointement de sorte qu'une partie de la grille (12) dudit V-FET à canal p (Q$_6$) fait fonction du drain ou de la source dudit MIS-FET à canal n (Q$_4$; Q''$_3$).

2. Circuit intégré logique complémentaire selon la revendication 1, dans lequel:

ladite partie de la grille (8) dudit V-FET à canal n (Q$_5$ fait fonction du drain dudit MIS-FET à canal p (Q$_3$);

ladite partie de la grille (12) dudit V-FET à canal p (Q$_6$) fait fonction du drain dudit MIS-FET à canal n (Q$_4$);

le drain (6) dudit V-FET à canal n (Q$_5$) est connecté à la source (9) dudit MIS-FET à canal p (Q$_3$) et reçoit la tension de source positive (V+); et

le drain (7) dudit V-FET à canal p (Q$_6$) est connecté à la source (13) dudit MIS-FET à canal n (Q$_4$) et reçoit une tension de source négative (V−).

3. Circuit intégré logique complémentaire selon la revendication 1, dans lequel:

ladite partie de la grille (8) dudit V-FET à canal n (Q$_5$) fait fonction de la source dudit MIS-FET à canal p (Q''$_4$);

ladite partie de la grille (12) dudit V-FET à canal p (Q$_6$) fait fonction de la source dudit MIS-FET à canal n (Q''$_3$);

le drain (6) dudit V-FET à canal n (Q$_5$) est connecté au drain (13) du MIS-FET à canal n (Q''$_3$) et reçoit la tension de source positive (V+); et

le drain (7) dudit V-FET à canal p (Q$_6$) est

connecté au drain (9) dudit MIS-FET à canal p (Q''$_4$) et reçoit une tension de source négative (V−).

4. Circuit intégré logique complémentaire selon l'une quelconque des revendications précédentes, comprenant:

un substrat semiconducteur de type p (1), sur lequel le circuit intégré est fabriqué;

une couche de type n⁻ (2) formée sur ledit substrat (1);

des couches enterrées de type n et de type p (3,4) fabriquées entre le substrat de type p (1) et ladite couche n⁻ (2), chacune des couches enterrées étant respectivement fortement dopée à l'aide d'une impureté de dopage de type n et d'une impureté de dopage de type p, et étant respectivement connectée à la surface du substrat par des régions fortement dopées (6, 7) des types de conductivité respectifs fabriquées à la périphérie des couches enterrées (3,4); et

une couche n⁻(2) et une couche p⁻(5) respectivement dopées légèrement à l'aide d'une impureté de dopage de type n et d'une impureté de dopage de type p et respectivement fabriquées sur ladite couche enterrée de type n (3) et ladite couche enterrée de type p (4),

où ladite couche n⁻ comprend un MIS-FET à canal p (Q$_3$; Q''$_4$) et un V-FET à canal n (Q$_5$) fabriqués conjointement de sorte qu'une partie de la grille (8) dudit V-FET à canal n (Q$_5$) fait fonction du drain ou de la source dudit MIS-FET à canal p (Q$_3$; Q''$_4$); et

ladite couche p⁻ comprend un MIS-FET à canal n (Q$_4$, Q''$_3$) et un V-FET à canal p (Q$_6$) fabriqués conjointement de sorte, qu'une partie de la grille (12) du V-FET à canal p (Q$_6$) fait fonction du drain ou de la source dudit MIS-FET à canal n (Q$_4$; Q''$_3$).

5. Circuit logique complémentaire selon la revendication 4, dans lequel:

ladite couche n⁻(2) comprend:

une première région n⁺(10) qui est fortement dopée à l'aide d'une impureté de dopage de type n et est fabriquée à la partie formant la surface de ladite couche n⁻(2) de manière à constituer la source du V-FET à canal n (Q$_5$),

une première région p⁺(8) qui est fortement dopée à l'aide d'une impureté de dopage de type p et est fabriquée à la partie formant la surface de ladite couche n⁻(2) afin de constituer la grille dudit V-FET à canal n (Q$_5$) et, simultanément, la source ou le drain du MIS-FET à canal p,

une deuxième région p⁺(9) qui est fortement dopée à l'aide d'une impureté de dopage de type p et est fabriquée à la partie formant la surface de ladite couche n⁻(2) afin de constituer la source ou le drain du MIS-FET à canal p, et

une électrode de grille isolée (11) fabriquée à la surface de ladite couche n⁻(2) entre les première et deuxième régions p⁺ (8, 9);

ladite couche p⁻(5) comprend:

une troisième région p⁺(14) qui est fortement dopée à l'aide d'une impureté de dopage de type p et est fabriquée à la partie formant la surface de ladite couche p⁻(5) afin de constituer la source du V-FET à canal p (Q₆),

une deuxième région n⁺(12) qui est fortement dopée à l'aide d'une impureté de dopage de type n et est fabriquée à la partie formant la surface de ladite couche p⁻(5) afin de constituer la grille dudit V-FET à canal p (Q₆) et, simultanément, le drain ou la source du MIS-FET à canal n,

une troisième région n⁺(13) qui est fortement dopée à l'aide d'une impureté de dopage de type n et est fabriquée à la partie formant la surface de ladite couche p⁻(5) afin de constituer la source ou le drain du MIS-FET à canal n, et

une électrode de grille isolée (15) fabriquée à la surface de ladite couche p⁻(5) entre les deuxième et troisième régions n⁺ (12, 13).

6. Circuit intégré logique complémentaire selon la revendication 5, ou:

la première région p⁺(8) est fabriquée autour de la première région n⁺(10); et

la deuxième région n⁺(12) est fabriquée autour de la troisième région p⁺(14).

7. Circuit logique complémentaire possédant une borne d'entrée destinée à recevoir un signal d'entrée et une borne de sortie destinée à produire un signal de sortie inversé, dans lequel:

une alimentation en tension de source est dotée de bornes formant un côté positif (V+) et un côté négatif (V−);

un circuit de premier étage comprend un MIS-FET à canal p (Q₃) et un MIS-FET à canal n (Q₄),

ledit MIS-FET à canal p (Q₃ possédant une source (9) qui est connectée à la borne positive (V+), et une grille (11) connectée à la borne d'entrée (IN),

ledit MIS-FET à canal n (Q₄) possédant un drain (12) qui est connecté au drain (8) du MIS-FET à canal p (Q₃), une grille (15) qui est connectée à la borne d'entrée (IN), et une source (13) qui est connectée à la borne négative (V−),

les régions de canal dudit MIS-FET à canal p (Q₃) et dudit MIS-FET à canal n (Q₄) étant respectivement polarisées par la tension positive (V+) et la tension négative (V−) de ladite alimentation en tension, et

un circuit d'étage de sortie comprend un V-FET à canal p (Q₆) et un V-FET à canal n (Q₅),

le V-FET à canal n (Q₅) possédant un drain (6) qui est connecté à la borne positive (V+), une grille (8) qui est connectée au drain du MIS-FET à canal p (Q₃), et une source (10) qui est connectée à la borne de sortie (OUT), et

le V-FET à canal p (Q₆) possédant une source (14) qui est connectée à la borne de sortie (OUT), une grille (12) qui est connectée au drain du MIS-FET à canal n (Q₄), et un drain (7) qui est connecté à la borne négative (V−).

8. Circuit logique complémentaire possédant une borne d'entrée destinée à recevoir un signal d'entrée et une borne de sortie destinée à produire un signal de sortie non inversé, dans lequel:

une alimentation en tension de source est dotée de bornes formant un côté positif (V+) et un côté négatif (V−);

un circuit de premier étage comprend un MIS-FET à canal n (Q''₃) et un MIS-FET à canal p (Q''₄),

ledit MIS-FET à canal n (Q''₃) possédant un drain (13) qui est connecté à la borne positive (V+) et une grille (15) qui est connectée à la borne d'entrée (IN),

le MIS-FET à canal p (Q''₄) possédant une source (8) qui est connectée à la source (12) du MIS-FET à canal n (Q''₃), une grille (11) qui est connectée à la borne d'entrée (IN), et un drain (9) qui est connecté à la borne négative (V−),

les régions de canal desdits MIS-FET à canal n (Q''₃) et à canal p (Q''₄) sont respectivement polarisées à l'aide de tensions négative (V−) et positive (V+) de l'alimentation en tension, et

un circuit d'étage de sortie comprend un V-FET à canal p (Q₆) et un V-FET à canal n (Q₅),

ledit V-FET à canal n (Q₅) possédant un drain (6) qui est connecté à la borne positive (V+), une grille (8) qui est connectée à la source du MIS-FET à canal p (Q''₄), et une source (10) qui est connectée à la borne de sortie (OUT), et

le V-FET à canal p (Q₆) possédant une source (14) qui est connectée à la borne de sortie (OUT), une grille (12) qui est connectée à la source du MIS-FET à canal n (Q''₃), et un drain (7) qui est connecté à la borne négative (V−).

## *FIG. 1a* <u>PRIOR ART</u>

## *FIG. 1b* <u>PRIOR ART</u>

# FIG. 2a

PRIOR ART

# FIG. 2b

# FIG. 3a

# FIG. 3b

FIG. 4

FIG. 5